# EUROPEAN PATENT APPLICATION

(11) **EP 4 603 790 A1**
(43) Date of publication of application: **20.08.2025**
(21) Application number: 23900259.5
(22) Date of filing: 01.09.2023
(51) Int. Cl.: G01B 11/06

(54) **FILM THICKNESS MEASUREMENT DEVICE AND FILM THICKNESS MEASUREMENT METHOD**

(30) Priority: 06.12.2022 JP 2022194697
(71) Applicant: Hamamatsu Photonics K.K., Hamamatsu-shi, Shizuoka 435-8558 (JP)
(72) Inventor: OHTSUKA Kenichi, Hamamatsu-shi, Shizuoka 435-8558 (JP); MASUOKA Hideki, Hamamatsu-shi, Shizuoka 435-8558 (JP); IGUCHI Kazuya, Hamamatsu-shi, Shizuoka 435-8558 (JP)
(74) Representative: Grünecker Patent- und Rechtsanwälte PartG mbB
(86) International application number: PCT/JP2023/032089
(87) International publication number: WO 2024/122133

(57) **Abstract**

In a film thickness measurement device 1, spectral images P of measurement light L are received by a first pixel region 21A with a first type of exposure time T1 and spectral images P of measurement light L are received by a second pixel region 21B with a second type of exposure time T2 longer than the first type of exposure time T1, and data in a long wavelength region in a first type of measurement spectrum data S1 obtained from the first pixel region 21A and data in a short wavelength region in a second type of measurement spectrum data S2 obtained from the second pixel region 21B are combined to generate spectrum data for analysis Ds.

## Description

### Technical Field

The present disclosure relates to a film thickness measurement device and a film thickness measurement method.

### Background Art

Development of a film thickness measurement device using spectral separation is being advanced in view of application to an in-line film thickness monitor or the like. The amount of change in the reflectance spectrum with respect to the film thickness of a multilayer film tends to be larger in the ultraviolet region than in the visible region. Thus, in the current situation where multilayering and thinning of devices are in progress, performing spectral separation using light in the ultraviolet region is presumed to be effective from the viewpoint of improvement in measurement accuracy. However, in the case where light in the ultraviolet region is handled, there are various technical problems such as stray light, dispersion, scattering, luminance, durability, and cost. In particular, when the intensity of light in the visible region greatly exceeds the intensity of light in the ultraviolet region, in the detection system the exposure time is limited to a range in which the sensitivity to light in the visible region is not saturated, and there is a concern that it will be difficult to obtain a required sensitivity to light in the ultraviolet region.

With regard to such a problem, for example, a film thickness measurement device described in Patent Literature 1 includes an optical unit including an input unit to which light of wavelengths ranging from the ultraviolet region to the visible region is inputted, an optical system that condenses light in a state where a chromatic aberration is brought about, and an opening at which, among the components of light with which a chromatic aberration occurs, light of wavelengths in the visible region does not form an image and light of wavelengths in the ultraviolet region forms an image. In this optical unit, the spectrum intensity in the ultraviolet region of light outputted from the opening can be increased relative to the spectrum intensity in the visible region.

### Citation List

### Patent Literature

Patent Literature 1: WO 2021/106299 A

### Summary of Invention

### Technical Problem

A film thickness measurement device like that of Patent Literature 1 described above is significant in that a required sensitivity to light in the ultraviolet region is easily obtained in the detection system and an optimum spectrum for film thickness measurement can be configured. On the other hand, when using such a device for in-line film thickness measurement, it is necessary to take into consideration the fact that reflection intensity (reflectance) for measurement light varies with the sample to be measured. For example, in the case where a curve fitting method is applied to reflectance data of a measured sample to calculate the film thickness, it is presumed that the accuracy of film thickness calculation will be enhanced by performing fitting taking into account spectrum intensities not only in the ultraviolet region but also in a long wavelength region including the visible region. On the premise of this, from the viewpoint of enhancing the versatility of in-line measurement of film thickness, a technology capable of arbitrarily adjusting a wavelength region in which spectrum intensity is relatively increased, the balance of detection intensity of measurement light between wavelength regions, etc. is needed.

The present disclosure has been made to solve the above issue, and an object of the present disclosure is to provide a film thickness measurement device and a film thickness measurement method capable of enhancing the versatility of in-line measurement of film thickness.

### Solution to Problem

A film thickness measurement device according to an aspect of the present disclosure includes: a spectral separation unit configured to spectrally separate measurement light outputted from a light source and reflected by a sample; a detection unit configured to detect spectral images of the measurement light spectrally separated by the spectral separation unit; a generation unit configured to generate spectrum data for analysis by using spectrum data obtained from a result of detection of spectral images of the measurement light; and an analysis unit configured to analyze the film thickness of the sample on the basis of the spectrum data for analysis; in the film thickness measurement device, the spectral separation unit subjects the measurement light to wavelength resolution in a first direction and forms spectral images on a wavelength basis each in a second direction intersecting the first direction, the detection unit has a first pixel region and a second pixel region divided in the second direction, and receives spectral images of the measurement light with the first pixel region with a first type of exposure time and receives spectral images of the measurement light with the second pixel region with a second type of exposure time longer than the first type of exposure time, and the generation unit combines data in a long wavelength region in a first type of measurement spectrum data obtained from the first pixel region and data in a short wavelength region in a second type of measurement spectrum data obtained from the second pixel region, and generates spectrum data for analysis.

In this film thickness measurement device, data in a long wavelength region of a first type of measurement spectrum data acquired in the first pixel region with a first type of exposure time and data in a short wavelength region of a second type of measurement spectrum data acquired in the second pixel region with a second type of exposure time longer than the first type of exposure time are combined, and spectrum data for analysis used for analysis of the film thickness of the sample is generated. The generated spectrum data for analysis includes data in the short wavelength region in a state where the sensitivity to measurement light in the short wavelength region is sufficiently enhanced. By using such spectrum data for analysis to perform curve fitting on spectrum data including the ultraviolet region and the visible region, the accuracy of film thickness measurement can be enhanced. Further, in this film thickness measurement device, the first type of measurement spectrum data and the second type of measurement spectrum data are independently acquired by the first pixel region and the second pixel region; thus, in the generation of spectrum data for analysis, the boundary wavelength of the combination of the first type of measurement spectrum data and the second type of measurement spectrum data can be arbitrarily set, and accordingly the intensity balance between data in the long wavelength region and data in the short wavelength region can be arbitrarily adjusted. Therefore, even when reflection intensity (reflectance) with respect to measurement light varies with the sample, conditions for acquiring spectrum data of samples can be optimized, and the versatility of in-line measurement of film thickness can be enhanced.

The detection unit may be a CCD photodetector including a first horizontal shift register to which charge generated in each column of the first pixel region is transferred and a second horizontal shift register to which charge generated in each column of the second pixel region is transferred. By such a configuration, the readout of the charge of each pixel corresponding to the spectral image of measurement light received with the first pixel region and the readout of the charge of each pixel corresponding to the spectral image of measurement light received with the second pixel region can be performed in parallel. Further, by using the CCD photodetector, an increase in readout noise when reading out charge generated in the pixels of each column can be avoided.

The detection unit may be a CCD photodetector including a first accumulation unit in which charge generated in each column of the first pixel region is accumulated, a second accumulation unit in which charge generated in each column of the second pixel region is accumulated, a first readout unit that outputs an electrical signal of each column according to the amount of charge accumulated in the first accumulation unit, and a second readout unit that outputs an electrical signal of each column according to the amount of charge accumulated in the second accumulation unit. Also in such a configuration, the readout of the charge of each pixel corresponding to the spectral image of measurement light received with the first pixel region and the readout of the charge of each pixel corresponding to the spectral image of measurement light received with the second pixel region can be performed in parallel. Further, by using the CCD photodetector, an increase in readout noise when reading out charge generated in the pixels of each column can be avoided.

The detection unit may be a CMOS photodetector including a first readout unit that outputs charge generated in each column of the first pixel region and a second readout unit that outputs charge generated in each column of the second pixel region. Also in such a configuration, the readout of the charge of each pixel corresponding to the spectral image of measurement light received with the first pixel region and the readout of the charge of each pixel corresponding to the spectral image of measurement light received with the second pixel region can be performed in parallel.

The generation unit may set a boundary wavelength between data in the long wavelength region in the first type of measurement spectrum data and data in the short wavelength region in the second type of measurement spectrum data when generating spectrum data for analysis on the basis of the exposure time ratio between the first pixel region and the second pixel region and an estimated value of reflection spectrum data in the sample. By using, as indices, the exposure time ratio between the first pixel region and the second pixel region and an estimated value of reflection spectrum data in the sample, data in the long wavelength region of the first type of measurement spectrum data and data in the short wavelength region of the second type of measurement spectrum data can be combined in a state where the intensity balance between the first type of measurement spectrum data and the second type of measurement spectrum data is optimized. By performing curve fitting on such spectrum data for analysis, the accuracy of film thickness measurement can be enhanced still further.

The generation unit may set the boundary wavelength from wavelengths at which the peak intensity of measurement light included in the data in the short wavelength region is 80% or more and less than 100% of the saturation intensity. Thereby, the intensity balance between the first type of measurement spectrum data and the second type of measurement spectrum data can be optimized still further.

A film thickness measurement method according to an embodiment of the present disclosure includes: a spectral separation step of spectrally separating measurement light outputted from a light source and reflected by a sample; a detection step of detecting spectral images of the measurement light spectrally separated by the spectral separation step; a generation step of generating spectrum data for analysis by using spectrum data obtained from a result of detection of spectral images of the measurement light; and an analysis step of analyzing the film thickness of the sample on the basis of the spectrum data for analysis; in the film thickness measurement method, the spectral separation step subjects the measurement light to wavelength resolution in a first direction and forms spectral images on a wavelength basis each in a second direction intersecting the first direction, the detection step uses a first pixel region and a second pixel region divided in the second direction to receive spectral images of the measurement light with the first pixel region with a first type of exposure time and receive spectral images of the measurement light with the second pixel region with a second type of exposure time longer than the first type of exposure time, and the generation step combines data in a long wavelength region in a first type of measurement spectrum data obtained from the first pixel region and data in a short wavelength region in a second type of measurement spectrum data obtained from the second pixel region, and generates spectrum data for analysis.

In this film thickness measurement method, data in the long wavelength region of the first type of measurement spectrum data acquired in the first pixel region with the first type of exposure time and data in the short wavelength region of the second type of measurement spectrum data acquired in the second pixel region with the second type of exposure time longer than the first type of exposure time are combined, and spectrum data for analysis used for analysis of the film thickness of the sample is generated. The generated spectrum data for analysis includes data in the short wavelength region in a state where the sensitivity to measurement light in the short wavelength region is sufficiently enhanced. By using such spectrum data for analysis to perform curve fitting on spectrum data including the ultraviolet region and the visible region, the accuracy of film thickness measurement can be enhanced. Further, in this film thickness measurement method, the first type of measurement spectrum data and the second type of measurement spectrum data are independently acquired by the first pixel region and the second pixel region; thus, in the generation of spectrum data for analysis, the boundary wavelength of the combination of the first type of measurement spectrum data and the second type of measurement spectrum data can be arbitrarily set, and accordingly the intensity balance between data in the long wavelength region and data in the short wavelength region can be arbitrarily adjusted. Therefore, even when reflection intensity (reflectance) with respect to measurement light varies with the sample, conditions for acquiring spectrum data of samples can be optimized, and the versatility of in-line measurement of film thickness can be enhanced.

### Advantageous Effects of Invention

According to the present disclosure, the versatility of in-line measurement of film thickness can be enhanced.

### Brief Description of Drawings

FIG. 1 is a schematic diagram showing a film thickness measurement device according to an embodiment of the present disclosure.
FIG. 2 is a schematic diagram showing a situation of formation of spectral images of measurement light in a detection unit.
FIG. 3 is a diagram showing an example of a CCD photodetector included in the detection unit.
FIG. 4 is a diagram showing another example of a CCD photodetector included in the detection unit.
FIG. 5 is a diagram showing another example of a CCD photodetector included in the detection unit.
FIG. 6 is a diagram showing an example of a CMOS photodetector included in the detection unit.
FIG. 7 is a flowchart showing a film thickness measurement method according to an embodiment of the present disclosure.
FIG. 8(a) is a diagram showing an example of a first type of measurement spectrum data, and FIG. 8(b) is a diagram showing an example of a second type of measurement spectrum data.
FIG. 9(a) is a diagram showing an example of a first type of reference spectrum data, and FIG. 9(b) is a diagram showing an example of a second type of reference spectrum data.
FIG. 10(a) is a diagram showing an example of spectrum data for analysis, and FIG. 10(b) is a diagram showing an example of reference spectrum data for analysis.
FIG. 11(a) is a diagram showing an example of reflectance spectrum data obtained by a technique according to a Comparative Example, and FIG. 11(b) is a diagram showing an example of reflectance spectrum data obtained by a technique according to an Example.
FIG. 12(a) is a schematic diagram showing reflection spectrum data for a reference sample, FIG. 12(b) is a schematic diagram showing rough reflectance spectrum data of a sample, FIG. 12(c) is a schematic diagram showing an estimated value of reflection spectrum data of the sample, and FIG. 12(d) is a schematic diagram showing a relationship of saturation intensity with respect to the estimated value of reflection spectrum data of the sample.
FIG. 13 is a schematic diagram illustrating an example of setting of a boundary wavelength.
FIG. 14 is a diagram showing results of reproducibility evaluation of film thickness measurement in a Comparative Example.
FIG. 15 is a diagram showing results of reproducibility evaluation of film thickness measurement in an Example.

### Description of Embodiments

Hereinbelow, preferred embodiments of a film thickness measurement device and a film thickness measurement method according to an aspect of the present disclosure are described in detail with reference to the drawings.

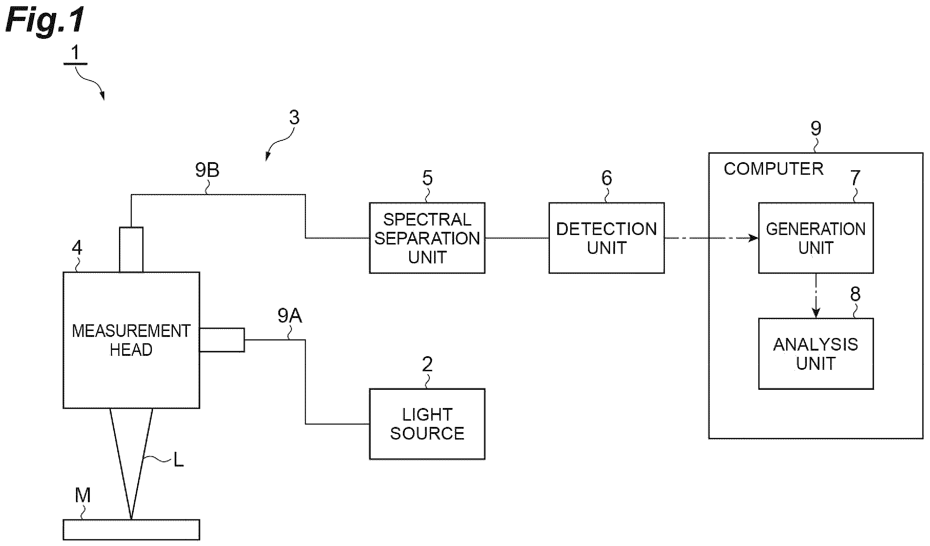

FIG. 1 is a schematic diagram showing a film thickness measurement device according to an embodiment of the present disclosure. A film thickness measurement device 1 shown in FIG. 1 is configured as a device that, for example in a film formation process of a sample M using a film formation chamber, performs in-line measurement of the film thickness of the sample M. Examples of the sample M include an optical film, a thin film for a display panel, and a thin film for a semiconductor wafer. The film thickness measurement device 1 includes a light source 2, an optical system 3, a measurement head 4, a spectral separation unit 5, a detection unit 6, a generation unit 7, and an analysis unit 8.

The light source 2 is a device that outputs measurement light L toward the sample M. As the light source 2, for example, a white light source that outputs light including a wavelength region of 185 nm or more and 2000 nm or less is used. As the light source 2, for example, a light source (for example, a xenon flash lamp) that outputs pulsed light having a repetition frequency of 1 kHz or more is used.

The optical system 3 is a system that guides measurement light L between the light source 2, the measurement head 4, and the spectral separation unit 5. In the present embodiment, the optical system 3 includes a first optical fiber 9A and a second optical fiber 9B. The first optical fiber 9A is an optical fiber that guides measurement light L from the light source 2 to the measurement head 4. The second optical fiber 9B is an optical fiber that guides measurement light L from the measurement head 4 to the spectral separation unit 5.

The measurement head 4 is a portion that irradiates the sample M with measurement light L. The measurement head 4 includes, for example, a half mirror and a condensing lens. The measurement light L inputted from the light source 2 to an input terminal of the measurement head 4 via the first optical fiber 9A is applied to the sample M via the half mirror and the condensing lens. The measurement light L reflected by the sample M is outputted from an output terminal of the measurement head 4 via the condensing lens and the half mirror, and is inputted to the spectral separation unit 5 via the second optical fiber 9B.

The spectral separation unit 5 is a portion that spectrally separates measurement light L outputted from the light source 2 and reflected by the sample M. As the spectral separation unit 5, a spectrometer having good image formation properties is used. Examples of the spectrometer included in the spectral separation unit 5 include a Czerny-Turner-type spectrometer, a Dyson-type spectrometer, and an Offner-type spectrometer that are capable of astigmatism correction.

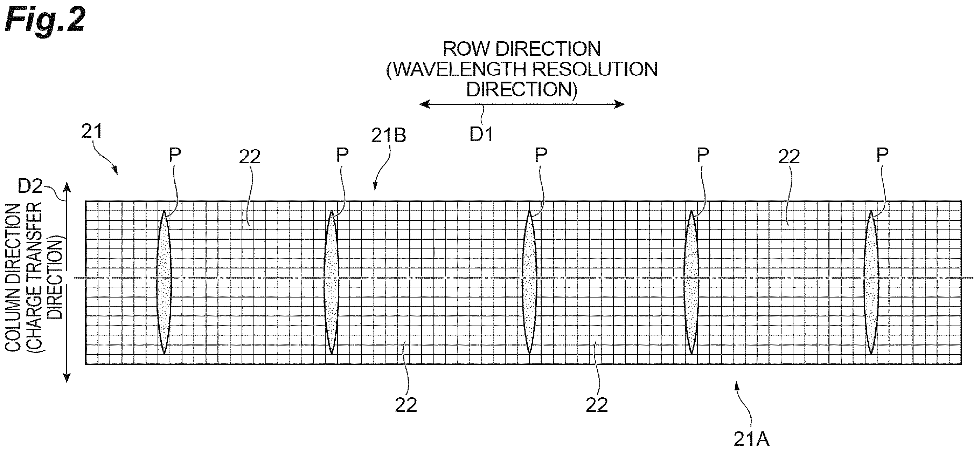

As shown in, for example, FIG. 2, the spectral separation unit 5 subjects measurement light L to wavelength resolution in a first direction D1, and forms spectral images P on a wavelength basis each in a second direction D2 intersecting the first direction D1. Herein, the first direction D1 and the second direction D2 are directions orthogonal to each other. In the example of FIG. 2, the first direction D1 is along the row direction of a pixel region 21 included in the detection unit 6, and the second direction D2 is along the column direction of the pixel region 21.

The detection unit 6 is a portion that detects spectral images P of measurement light L spectrally separated by the spectral separation unit 5. As shown in FIG. 2, the detection unit 6 has a pixel region 21 where spectral images P are captured. In the pixel region 21, a plurality of pixels 22 are arranged in the row direction and the column direction. In the example of FIG. 2, the row direction corresponding to the first direction D1 is along the direction of wavelength resolution of spectral images P by the spectral separation unit 5, and the column direction corresponding to the second direction D2 is along the charge transfer direction of each pixel 22. Each pixel 22 receives a spectral image P subjected to wavelength resolution, and generates and accumulates charge according to the intensity of light.

In the example in FIG. 2, the pixel region 21 forms a horizontally long rectangular region in which the number of pixels in the row direction is larger than the number of pixels in the column direction. The pixel region 21 has a first pixel region 21A and a second pixel region 21B divided in the second direction D2. Herein, the first pixel region 21A and the second pixel region 21B are partitioned at the center in the column direction. That is, in the pixel region 21, the pixels 22 on one side of the center in the column direction belong to the first pixel region 21A, and the pixels 22 on the other side of the center in the column direction belong to the second pixel region 21B.

Spectral images P each extend in a straight line in the column direction of pixels 22, and are formed in a first pixel region 21A and a second pixel region 21B in a state of being apart from each other in the row direction. In the example of FIG. 2, a half portion on one side in the second direction D2 of each of the five spectral images P of measurement light L that has been subjected to wavelength resolution by the spectral separation unit 5 is formed in the first pixel region 21A. Further, a half portion on the other side in the second direction D2 of each of the five spectral images P of measurement light L that has been subjected to wavelength resolution by the spectral separation unit 5 is formed in the second pixel region 21B at the same timing as the formation of the spectral image P in the first pixel region 21A. The detection unit 6 outputs, to the analysis unit 8, data (a first type of measurement spectrum data S1) based on the detection result in the first pixel region 21A and data (a second type of measurement spectrum data S2) based on the detection result in the second pixel region 21B.

A first type of exposure time T1 of each pixel 22 in the first pixel region 21A and a second type of exposure time T2 of each pixel 22 in the second pixel region 21B can be set independently of each other. The exposure time ratio T2/T1 between the first pixel region 21A and the second pixel region 21B is set according to the type of the film in the sample M, etc. Also a scheme in which the first type of exposure time T1 of the first pixel region 21A is fixed and the second type of exposure time T2 of the second pixel region 21B is adjusted according to the type of the film in the sample M, etc. is possible.

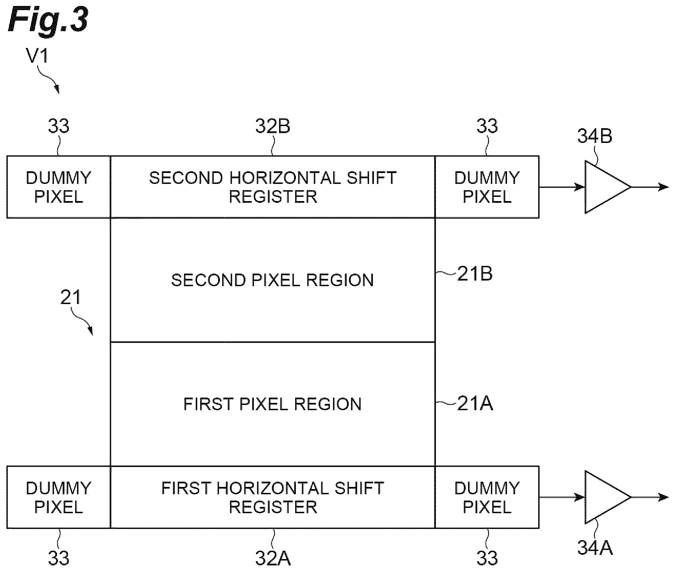

The detection unit 6 can be configured by, for example, CCD photodetection or a CMOS photodetector. FIG. 3 is a diagram showing an example of a CCD photodetector included in the detection unit. A CCD photodetector V1 shown in FIG. 3 includes the pixel region 21 including the first pixel region 21A and the second pixel region 21B described above, a first horizontal shift register 32A corresponding to the first pixel region 21A, a second horizontal shift register 32B corresponding to the second pixel region 21B, and a plurality of dummy pixels 33.

The charge generated and accumulated in each pixel 22 of the first pixel region 21A is transferred to the first horizontal shift register 32A. In the transfer, the charges of the pixels 22 of each column are added together on a column basis in the first horizontal shift register 32A (vertical transfer), and the charges added on a column basis are sequentially read out from the first horizontal shift register 32A (horizontal transfer). A voltage value according to the amount of charge read out from the first horizontal shift register 32A is outputted from an amplifier 34A. The voltage value outputted from the amplifier 34A is converted to a digital value by an AD converter.

The charge generated and accumulated in each pixel 22 of the second pixel region 21B is transferred to the second horizontal shift register 32B. In the transfer, the charges of the pixels 22 of each column are added together on a column basis in the second horizontal shift register 32B (vertical transfer), and the charges added on a column basis are sequentially read out from the second horizontal shift register 32B (horizontal transfer). A voltage value according to the amount of charge read out from the second horizontal shift register 32B is outputted from an amplifier 34B. The voltage value outputted from the amplifier 34B is converted to a digital value by an AD converter.

In the CCD photodetector V1, the first type of exposure time T1 of the first pixel region 21A and the second type of exposure time T2 of the second pixel region 21B can be set by, for example, an electronic shutter. The electronic shutter can be implemented by using, for example, an anti-blooming gate. The operation of outputting a signal from the first pixel region 21A and the operation of outputting a signal from the second pixel region 21B are independently controlled, but are preferably synchronized with each other. In this case, a situation where a signal making an instructing of one output operation overlaps with an output signal of the other output operation as noise can be prevented.

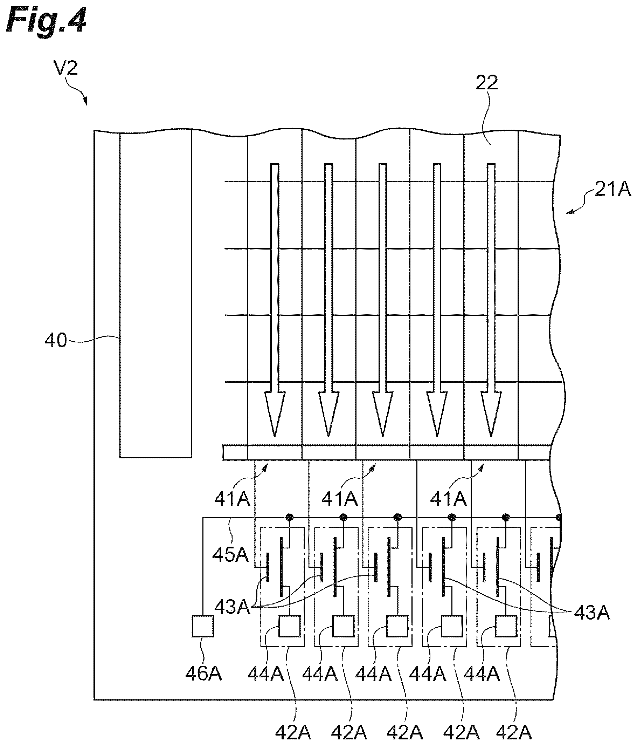

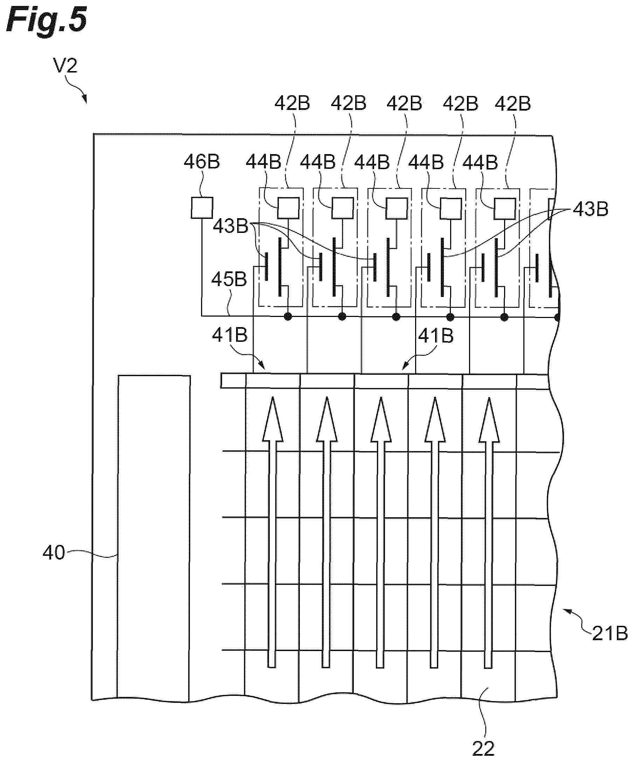

FIGS. 4 and 5 are diagrams showing another example of a CCD photodetector included in the detection unit. A CCD photodetector V2 shown in FIGS. 4 and 5 includes a conversion substrate 40, a first accumulation unit 41A in which charge generated in each column of the first pixel region 21A is accumulated, a second accumulation unit 41B in which charge generated in each column of the second pixel region 21B is accumulated, a first readout unit 42A that outputs an electrical signal of each column according to the magnitude of the charge accumulated in the first accumulation unit 41A, and a second readout unit 42B that outputs an electrical signal of each column according to the magnitude of the charge accumulated in the second accumulation unit 41B.

The conversion substrate 40 is placed along the column direction beside the pixel region 21. A voltage signal (drive signal) for controlling transfer of charge of the pixel 22 is supplied to the conversion substrate 40. The charge of the pixel 22 of each column belonging to the first pixel region 21A is transferred to the first accumulation unit 41A of the column on the basis of a voltage signal supplied to the conversion substrate 40. The charge of the pixel 22 of each column belonging to the second pixel region 21B is transferred to the second accumulation unit 41B of the column on the basis of a voltage signal supplied to the conversion substrate 40.

The first accumulation units 41A are arranged on a column basis in an end portion in the column direction of the first pixel region 21A, and accumulate charges generated in the pixels 22 of the respective columns of the first pixel region 21A. The second accumulation units 41B are arranged on a column basis in an end portion in the column direction of the second pixel region 21B, and accumulate charges generated in the pixels 22 of the respective columns of the second pixel region 21B. The first readout unit 42A is placed in a later stage of the first accumulation unit 41A in an end portion in the column direction of the first pixel region 21A, and the second readout unit 42B is placed in a later stage of the second accumulation unit 41B in an end portion in the column direction of the second pixel region 21B.

As shown in FIG. 4, the first readout unit 42A includes, for example, a transistor 43A and a bonding pad 44A for signal output. A control terminal (gate) of the transistor 43A is electrically connected to the first accumulation unit 41A. One current terminal (drain) of the transistor 43Ais electrically connected to a bonding pad 46A via a wiring line 45A provided in common over the columns of the first pixel region 21A. A voltage of a predetermined magnitude is applied to the bonding pad 46A at all times.

The other current terminal (source) of the transistor 43A is electrically connected to the bonding pad 44A for signal output. A voltage according to a first electrical signal outputted from the first accumulation unit 41A is applied to the control terminal of the transistor 43A. From the other current terminal of the transistor 43A, a current according to the applied voltage is outputted, and is taken out to the outside via the bonding pad 44A for signal output.

As shown in FIG. 5, the second readout unit 42B includes, for example, a transistor 43B and a bonding pad 44B for signal output. A control terminal (gate) of the transistor 43B is electrically connected to the second accumulation unit 41B. One current terminal (drain) of the transistor 43B is electrically connected to a bonding pad 46B via a wiring line 45B provided in common over the columns of the second pixel region 21B. A voltage of a predetermined magnitude is applied to the bonding pad 46B at all times.

The other current terminal (source) of the transistor 43B is electrically connected to the bonding pad 44B for signal output. A voltage according to a second electrical signal outputted from the second accumulation unit 41B is applied to the control terminal of the transistor 43B. From the other current terminal of the transistor 43B, a current according to the applied voltage is outputted, and is taken out to the outside via the bonding pad 44B for signal output.

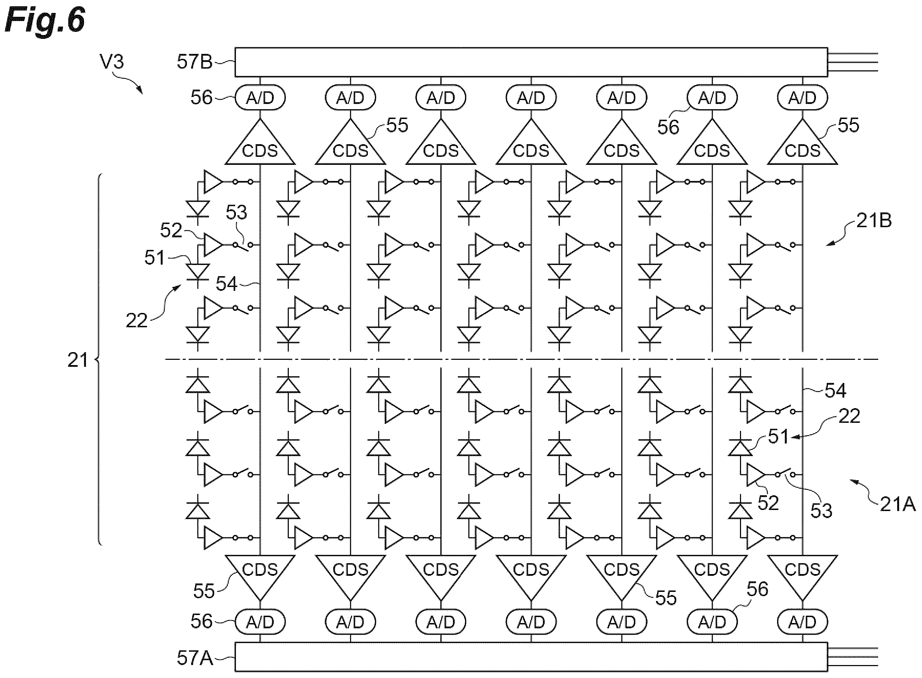

FIG. 6 is a diagram showing an example of a CMOS photodetector included in the detection unit. In a CMOS photodetector V3 shown in the drawing, each pixel 22 included in the pixel region 21 includes a photodiode 51 and an amplifier 52. The photodiode 51 accumulates, as a charge, electrons (photoelectrons) generated by input of light. The amplifier 52 converts the charge accumulated in the photodiode 51 to an electrical signal, and amplifies the signal after conversion.

By switching of a selection switch 53 of each pixel 22, the electrical signal amplified by the amplifier 52 is transferred to a vertical signal line 54 that connects the pixels 22 in the row direction to each other. A CDS (correlated double sampling) circuit 55 is placed for each vertical signal line 54. The CDS circuit 55 reduces readout noise between pixels 22, and temporarily stores the electrical signal transferred to the vertical signal line 54. The CDS circuit 55 is electrically connected to a conversion unit 56. The conversion unit 56 converts the voltage value outputted from the amplifier 52 of each pixel 22 to a digital value. In the present embodiment, the conversion unit 56 is configured by an A/D converter. The A/D converter converts the voltage value stored in the CDS circuit 55 to a digital value (pixel value).

The CMOS photodetector V3 includes a first readout unit 57A that outputs charge generated in each column of the first pixel region 21A and a second readout unit 57B that outputs charge generated in each column of the second pixel region 21B. The first readout unit 57A is connected to the A/D converter corresponding to the vertical signal line 54 of each pixel 22 belonging to the first pixel region 21A. The first readout unit 57A outputs a pixel value of each pixel 22 belonging to the first pixel region 21A. The second readout unit 57B is connected to the A/D converter corresponding to the vertical signal line 54 of each pixel 22 belonging to the second pixel region 21B. The second readout unit 57B outputs a pixel value of each pixel 22 belonging to the second pixel region 21B.

Returning to FIG. 1, the generation unit 7 and the analysis unit 8 will now be described. The generation unit 7 and the analysis unit 8 are each physically composed of, for example, a computer 9 including a processor such as a CPU and storage media such as a RAM and a ROM. The computer 9 may be a smartphone or a tablet terminal integrally provided with a display unit and an input unit. The computer 9 may be configured by a microcomputer or an FPGA (field-programmable gate array).

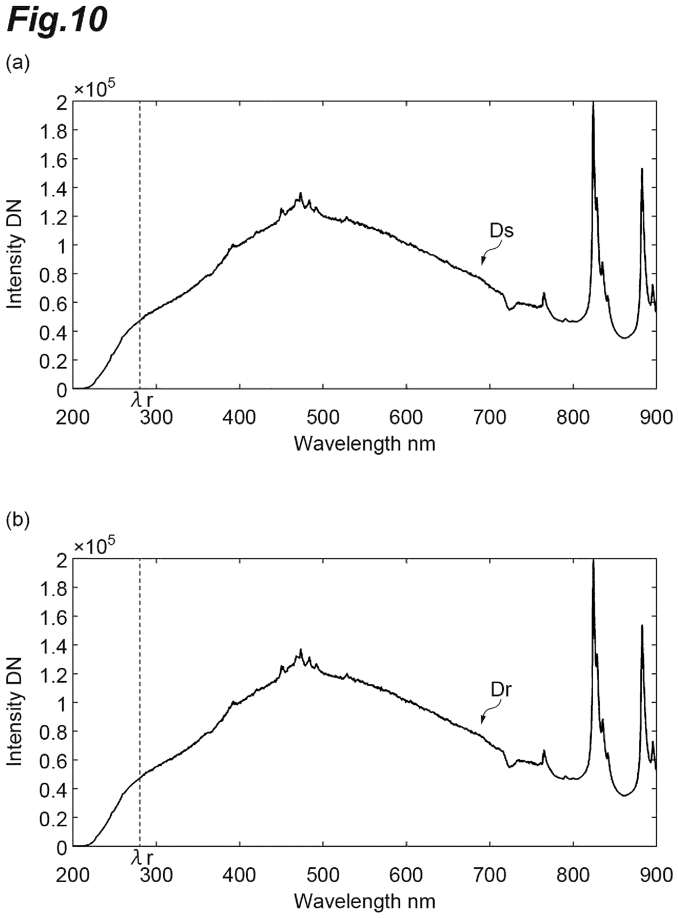

The generation unit 7 is a portion that generates spectrum data for analysis by using spectrum data obtained from a result of detection of spectral images P of measurement light L. The generation unit 7 combines data S1L in a long wavelength region in a first type of measurement spectrum data S1 obtained from the first pixel region 21A and data S2S in a short wavelength region in a second type of measurement spectrum data S2 obtained from the second pixel region 21B, and generates spectrum data for analysis Ds (see FIG. 10(a)). The generation unit 7 outputs the generated spectrum data for analysis Ds to the analysis unit 8.

Further, the generation unit 7 has previously held, for example, spectrum data (reference spectrum data) of measurement light L for a reference sample (not illustrated) of which the spectral reflectance data is known. The generation unit 7 combines data R1L in a long wavelength region in a first type of reference spectrum data R1 obtained from the first pixel region 21A and data R2S in a short wavelength region in a second type of reference spectrum data R2 obtained from the second pixel region 21B, and generates reference spectrum data for analysis Dr (see FIG. 10(b)). The generation unit 7 outputs the generated reference spectrum data for analysis Dr to the analysis unit 8.

The analysis unit 8 is a portion that analyzes the film thickness of the sample M on the basis of spectrum data for analysis Ds. The analysis unit 8 has previously held spectrum data (reflectance spectrum data for a reference Hr) regarding the reflectance of the reference sample. The analysis unit 8 calculates spectrum data (reflectance spectrum data for analysis Hs) regarding the reflectance of the sample M that is an object to be measured on the basis of the spectrum data for analysis Ds and the reference spectrum data for analysis Dr received from the generation unit 7, and the reflectance spectrum data for a reference Hr. The analysis unit 8 analyzes the film thickness of the sample M by curve fitting between the calculated reflectance spectrum data for analysis Hs and theoretical reflectance spectrum data.

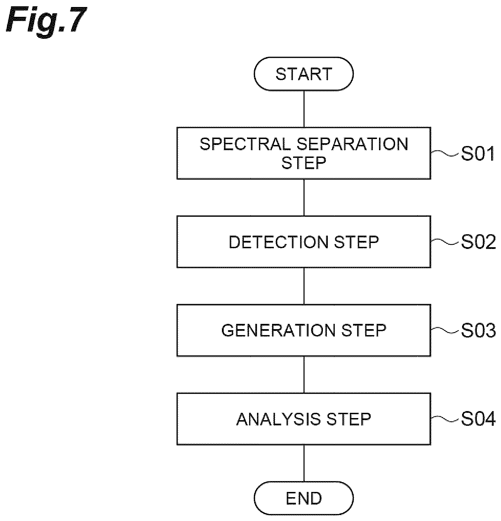

Next, a film thickness measurement method according to an embodiment of the present disclosure is described. FIG. 7 is a flowchart showing a film thickness measurement method according to an embodiment of the present disclosure. As shown in FIG. 7, this film thickness measurement method includes a spectral separation step S01, a detection step S02, a generation step S03, and an analysis step S04. A film thickness measurement method including step S01 to step S04 is performed using the film thickness measurement device 1 described above.

The spectral separation step S01 is a step of spectrally separating measurement light L outputted from the light source 2 and reflected by a sample M. In the spectral separation step S01, first, the measurement head 4 is set for a sample M to be measured for the film thickness. After the measurement head 4 is set, a first type of exposure time T1 of the first pixel region 21A and a second type of exposure time T2 of the second pixel region 21B are set. After the exposure time is set, the light source 2 is turned on, and measurement light L is outputted from the light source 2. The measurement light L reflected by the sample M is subjected to wavelength resolution by the spectral separation unit 5.

The detection step S02 is a step of detecting spectral images P of the measurement light L spectrally separated by the spectral separation step S01. In the detection step S02, spectral images P of the measurement light L subjected to wavelength resolution in the wavelength resolution direction (the first direction D1) are detected by the first pixel region 21A and the second pixel region 21B of the detection unit 6. In the detection step S02, spectral images P of the measurement light L are received by the first pixel region 21A with the first type of exposure time T1, and spectral images P of the measurement light L are received by the second pixel region 21B with the second type of exposure time T2 longer than the first type of exposure time T1. Thereby, a first type of measurement spectrum data S1 from the first pixel region 21A and a second type of measurement spectrum data S2 from the second pixel region 21B are acquired.

The generation step S03 is a step of generating spectrum data for analysis Ds by using spectrum data obtained from the result of detection of spectral images P of the measurement light L. More specifically, in the generation step S03, data S1L in a long wavelength region in the first type of measurement spectrum data S1 obtained from the first pixel region 21A and data S2S in a short wavelength region in the second type of measurement spectrum data S2 obtained from the second pixel region 21B are combined (connected) to generate spectrum data for analysis Ds. Further, in the generation step S03, data R1L in a long wavelength region in a first type of reference spectrum data R1 and data R2S in a short wavelength region in a second type of reference spectrum data R2 are combined (connected) to generate reference spectrum data for analysis Dr.

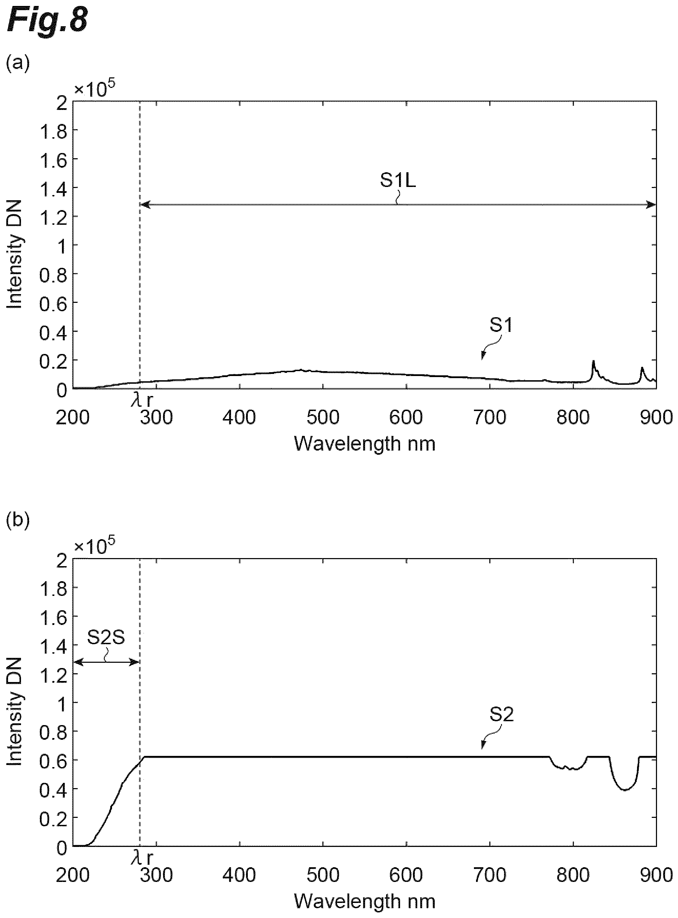

FIG. 8(a) is a diagram showing an example of the first type of measurement spectrum data S1. FIG. 8(b) is a diagram showing an example of the second type of measurement spectrum data S2. FIGS. 8(a) and 8(b) are examples of the first type of measurement spectrum data S1 and the second type of measurement spectrum data S2 when a silicon wafer with a SiO₂ film formed thereon is used as a sample M to be measured. In this case, the measurement light L reflected by the sample M has a certain intensity on the longer wavelength side than the ultraviolet region, but tends to have weaker intensity in the ultraviolet region than on the longer wavelength side.

The first type of measurement spectrum data S1 is data obtained by receiving spectral images P of the measurement light L in the first pixel region 21A with a relatively short first type of exposure time T1. In the example of the first type of measurement spectrum data S1 shown in FIG. 8(a), the intensity of measurement light L is detected with a certain sensitivity on the long wavelength side (for example, 300 nm or more), but fainter intensity is detected on the short wavelength side (for example, less than 300 nm) than on the long wavelength side.

The second type of measurement spectrum data S2 is data obtained by receiving spectral images P of the measurement light L in the second pixel region 21B with a relatively long second type of exposure time T2. Thus, in the example of the second type of measurement spectrum data S2 shown in FIG. 8(b), the intensity of measurement light L is saturated in the most part of the long wavelength side (for example, 300 nm or more), and sufficient intensity is detected on the short wavelength side (for example, less than 300 nm) as compared to the intensity on the short wavelength side of the first type of measurement spectrum data S1.

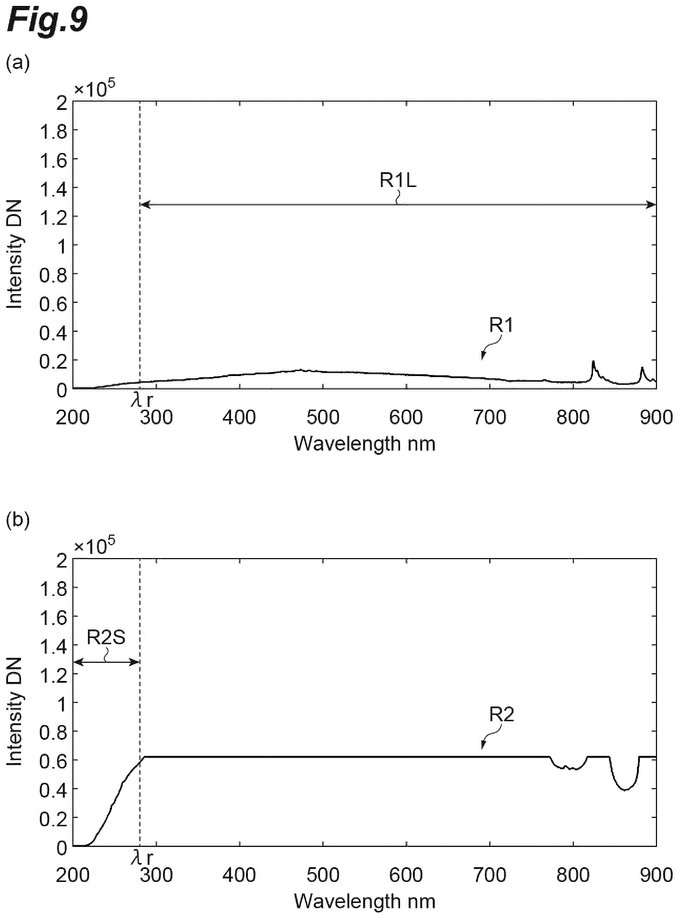

FIG. 9(a) is a diagram showing an example of the first type of reference spectrum data R1. FIG. 9(b) is a diagram showing an example of the second type of reference spectrum data R2. As described above, the reference spectrum data is spectrum data of measurement light L for a reference sample (not illustrated) of which the spectral reflectance data is known. Herein, the reference sample is a bare silicon wafer with no SiO₂ film formed thereon. In the present embodiment, a first type of reference spectrum data R1 and a second type of reference spectrum data R2 are acquired in advance by using the spectral separation unit 5 to spectrally separate measurement light L reflected by the reference sample and detecting the spectral images with the first pixel region 21A and the second pixel region 21B of the detection unit 6.

The waveform of the first type of reference spectrum data R1 and the waveform of the second type of reference spectrum data R2 follow the waveforms of the first type of measurement spectrum data S1 and the second type of measurement spectrum data S2. That is, in the example of the first type of reference spectrum data R1 shown in FIG. 9(a), the intensity of measurement light L is detected with a certain sensitivity on the long wavelength side (for example, 300 nm or more), but fainter intensity is detected on the short wavelength side (for example, less than 300 nm) than on the long wavelength side. In the example of the second type of reference spectrum data R2 shown in FIG. 9(b), the intensity of measurement light L is saturated in the most part of the long wavelength side (for example, 300 nm or more), and sufficient intensity is detected on the short wavelength side (for example, less than 300 nm) as compared to the intensity on the short wavelength side of the first type of reference spectrum data R1.

FIG. 10(a) is a diagram showing an example of spectrum data for analysis, and FIG. 10(b) is a diagram showing an example of reference spectrum data for analysis. In the example of FIG. 10(a), with the boundary wavelength λr set to 280 nm, data S1L in the long wavelength region in the first type of measurement spectrum data S1 and data S2S in the short wavelength region in the second type of measurement spectrum data S2 are combined to generate spectrum data for analysis Ds. In the spectrum data for analysis Ds, the intensity of measurement light L on the long wavelength side is not saturated, and the intensity of measurement light L is sufficiently obtained even on the short wavelength side.

The same boundary wavelength λr is used in the reference spectrum data for analysis Dr. In the example of FIG. 10(b), with the boundary wavelength λr set to 280 nm, data R1L in the long wavelength region in the first type of reference spectrum data R1 and data R2S in the short wavelength region in the second type of reference spectrum data R2 are combined to generate reference spectrum data for analysis Dr. Also in the reference spectrum data for analysis Dr, the intensity of measurement light L on the long wavelength side is not saturated, and the intensity of measurement light L is sufficiently obtained even on the short wavelength side.

The boundary wavelength λr can be arbitrarily set by the user of the film thickness measurement device 1 according to the type of the sample M, the reflection intensity (reflectance) for measurement light L, etc. When it is assumed that a silicon wafer with a SiO₂ film formed thereon is used as a sample M, the boundary wavelength λr is selected from, for example, a range of 200 nm or more and 500 nm or less, particularly wavelengths of 300 nm and its neighborhood.

The analysis step S04 is a step of analyzing the film thickness of the sample M on the basis of the spectrum data for analysis Ds. In a common film thickness calculation technique, first, reflectance spectrum data of the sample M is calculated by Formula (1) below. Then, the film thickness of the sample M is analyzed by curve fitting between the calculated spectrum data regarding the reflectance of the sample M and theoretical reflectance spectrum data. Spectrum data regarding the reflectance of the sample = (reflection spectrum data of the sample/reflection spectrum data of the reference sample) × spectrum data regarding the reflectance of the reference sample

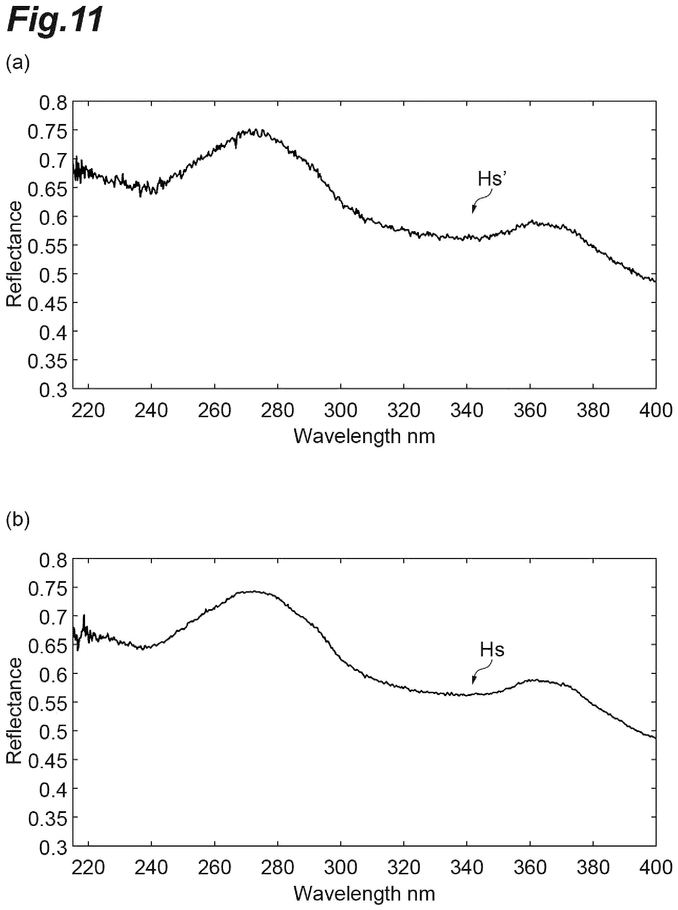

If applied to the present embodiment, the common calculation of spectrum data regarding the reflectance of a sample using Formula (1) above corresponds to, for example, a result obtained by dividing the first type of measurement spectrum data S1 shown in FIG. 8(a) by the first type of reference spectrum data R1 shown in FIG. 9(a) and multiplying the division result by reflectance spectrum data for a reference Hr. As shown in FIG. 11(a), reflectance spectrum data Hs' obtained by such a technique has a low S/N ratio over the entire measurement wavelength region, and has a tendency that it is difficult to obtain a certain level of S/N ratio particular on the short wavelength side.

In contrast, in the present embodiment, reflectance spectrum data for analysis Hs of the sample M is calculated by Formula (2) below. Then, the film thickness of the sample M is analyzed by curve fitting between the calculated reflectance spectrum data for analysis and theoretical reflectance spectrum data. Reflectance spectrum data for analysis = (spectrum data for analysis/reference spectrum data for analysis) × spectrum data regarding the reflectance of the reference sample

The calculation of reflectance spectrum data for analysis of the present embodiment using Formula (2) above corresponds to a result obtained by dividing the spectrum data for analysis Ds shown in FIG. 10(a) (that is, data generated by combining data S1L in the long wavelength region in the first type of measurement spectrum data S1 and data S2S in the short wavelength region in the second type of measurement spectrum data S2) by the reference spectrum data for analysis Dr shown in FIG. 10(b) (that is, data generated by combining data R1L in the long wavelength region in the first type of reference spectrum data R1 and data R2S in the short wavelength region in the second type of reference spectrum data R2) and multiplying the division result by reflectance spectrum data for a reference Hr. As shown in FIG. 11(b), reflectance spectrum data for analysis Hs obtained by such a technique has a better S/N ratio than the reflectance spectrum data Hs' shown in FIG. 11(a) over the entire measurement wavelength region, and has also an improved S/N ratio on the short wavelength side.

In the generation step S03 described above, the boundary wavelength λr used for combining data S1L in the long wavelength region in the first type of measurement spectrum data S1 and data S2S in the short wavelength region in the second type of measurement spectrum data S2 may be set based on the exposure time ratio T2/T1 between the first pixel region 21A and the second pixel region 21B and an estimated value F of reflection spectrum data in the sample M.

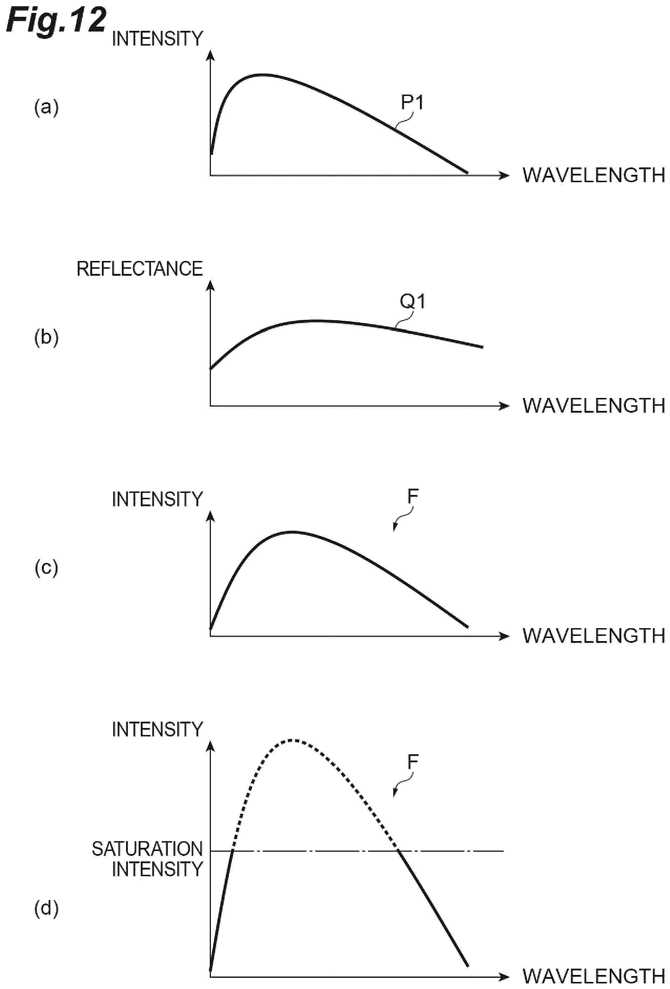

For the sample M, if the layer structure, the optical characteristics of each layer, and a rough thickness of each layer are known, rough reflectance spectrum data of the sample M can be calculated. Thus, an estimated value F of reflection spectrum data of the sample M can be calculated by multiplying reflection spectrum data P1 for the reference sample (see FIG. 12(a)) by rough reflectance spectrum data Q1 of the sample M (see FIG. 12(b)) (see FIG. 12(c)). Further, a relationship of the saturation intensity with respect to the estimated value F of reflection spectrum data of the sample M can be acquired by multiplying the calculated estimated value of reflection spectrum data of the sample M by the exposure time ratio T2/T1 (see FIG. 12(d)).

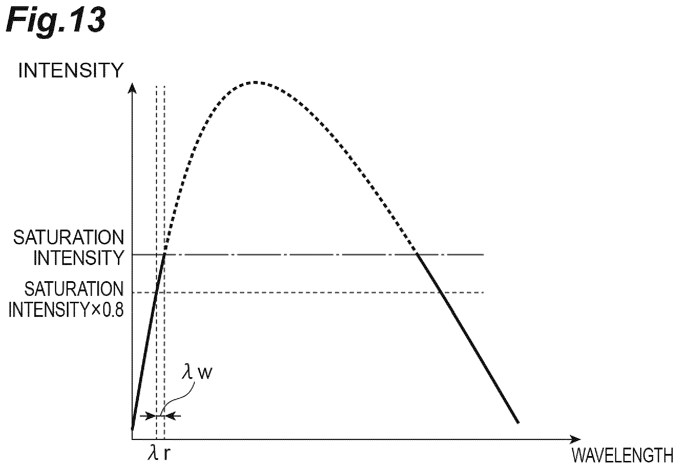

Next, as shown in FIG. 13, based on the relationship of the saturation intensity with respect to the estimated value F of reflection spectrum data of the sample M, a wavelength range λw in which the peak intensity of measurement light L included in the data in the short wavelength region is 80% or more and less than 100% of the saturation intensity is calculated, and a boundary wavelength λr is set from the range of λw. In the example of FIG. 13, the wavelength at which the peak intensity of measurement light L included in the data in the short wavelength region is 80% of the saturation intensity is set as a boundary wavelength λr.

The setting of the boundary wavelength λr is not limited to the above-described method, and the user of the film thickness measurement device 1 may set the boundary wavelength λr to an arbitrary value. In this case, for example, the second type of measurement spectrum data S2 may be displayed on a monitor, and the user of the film thickness measurement device 1 may set a boundary wavelength λr in a wavelength region in which the intensity of measurement light L is not saturated in the displayed second type of measurement spectrum data S2.

As described hereinabove, in the film thickness measurement device 1 and the film thickness measurement method according to the present embodiment, data S1L in a long wavelength region of a first type of measurement spectrum data S1 acquired in the first pixel region 21A with a first type of exposure time T1 and data S2S in a short wavelength region of a second type of measurement spectrum data S2 acquired in the second pixel region 21B with a second type of exposure time T2 longer than the first type of exposure time T1 are combined, and spectrum data for analysis Ds used for analysis of the film thickness of the sample M is generated. The generated spectrum data for analysis Ds includes data in the short wavelength region in a state where the sensitivity to measurement light in the short wavelength region is sufficiently enhanced. By using such spectrum data for analysis Ds to perform curve fitting on spectrum data including the ultraviolet region and the visible region, the accuracy of film thickness measurement can be enhanced.

Further, in the film thickness measurement device 1 and the film generation measurement method according to the present embodiment, the first type of measurement spectrum data S1 and the second type of measurement spectrum data S2 are independently acquired by the first pixel region 21A and the second pixel region 21B; thus, in the generation of spectrum data for analysis Ds, the boundary wavelength λr of the combination of the first type of measurement spectrum data S1 and the second type of measurement spectrum data S2 can be arbitrarily set, and accordingly the intensity balance between data S1L in the long wavelength region and data S2S in the short wavelength region can be arbitrarily adjusted. Therefore, even when reflection intensity (reflectance) with respect to measurement light L varies with the sample M, conditions for acquiring spectrum data of samples M can be optimized, and the versatility of in-line measurement of film thickness can be enhanced.

In the present embodiment, the detection unit 6 can be configured by a CCD photodetector V1 including a first horizontal shift register 32A to which charge generated in each column of the first pixel region 21A is transferred and a second horizontal shift register 32B to which charge generated in each column of the second pixel region 21B is transferred. By such a configuration, the readout of the charge of each pixel 22 corresponding to the spectral image P of measurement light L received with the first pixel region 21A and the readout of the charge of each pixel 22 corresponding to the spectral image P of measurement light L received with the second pixel region 21B can be performed in parallel. Further, by using the CCD photodetector V1, an increase in readout noise when reading out charge generated in the pixels 22 of each column can be avoided.

In the present embodiment, the detection unit 6 can be configured by a CCD photodetector V2 including a first accumulation unit 41A in which charge generated in each column of the first pixel region 21A is accumulated, a second accumulation unit 41B in which charge generated in each column of the second pixel region 21B is accumulated, a first readout unit 42A that outputs an electrical signal of each column according to the amount of charge accumulated in the first accumulation unit 41A, and a second readout unit 42B that outputs an electrical signal of each column according to the amount of charge accumulated in the second accumulation unit 41B. Also in such a configuration, the readout of the charge of each pixel 22 corresponding to the spectral image P of measurement light L received with the first pixel region 21A and the readout of the charge of each pixel 22 corresponding to the spectral image P of measurement light L received with the second pixel region 21B can be performed in parallel. Further, by using the CCD photodetector V2, an increase in readout noise when reading out charge generated in the pixels of each column can be avoided.

In the present embodiment, the detection unit 6 can be configured by a CMOS photodetector V3 including a first readout unit 57A that outputs charge generated in each column of the first pixel region 21A and a second readout unit 57B that outputs charge generated in each column of the second pixel region 21B. Also in such a configuration, the readout of the charge of each pixel 22 corresponding to the spectral image P of measurement light L received with the first pixel region 21A and the readout of the charge of each pixel 22 corresponding to the spectral image P of measurement light L received with the second pixel region 21B can be performed in parallel.

In the present embodiment, the generation unit 7 sets a boundary wavelength λr between data S1L in the long wavelength region in the first type of measurement spectrum data S1 and data S2S in the short wavelength region in the second type of measurement spectrum data S2 when generating spectrum data for analysis Ds on the basis of the exposure time ratio T2/T1 between the first pixel region 21A and the second pixel region 21B and an estimated value F of reflection spectrum data in the sample M. By using, as indices, the exposure time ratio T2/T1 between the first pixel region 21A and the second pixel region 21B and an estimated value F of reflection spectrum data in the sample M, data S1L in the long wavelength region of the first type of measurement spectrum data S1 and data S2S in the short wavelength region of the second type of measurement spectrum data S2 can be combined in a state where the intensity balance between the first type of measurement spectrum data S1 and the second type of measurement spectrum data S2 is optimized. By performing curve fitting on such spectrum data for analysis Ds, the accuracy of film thickness measurement can be enhanced still further.

In the present embodiment, the generation unit 7 sets the boundary wavelength λr from wavelengths at which the peak intensity of measurement light L included in the data in the short wavelength region is 80% or more and less than 100% of the saturation intensity. Thereby, the intensity balance between the first type of measurement spectrum data S1 and the second type of measurement spectrum data S2 can be optimized still further.

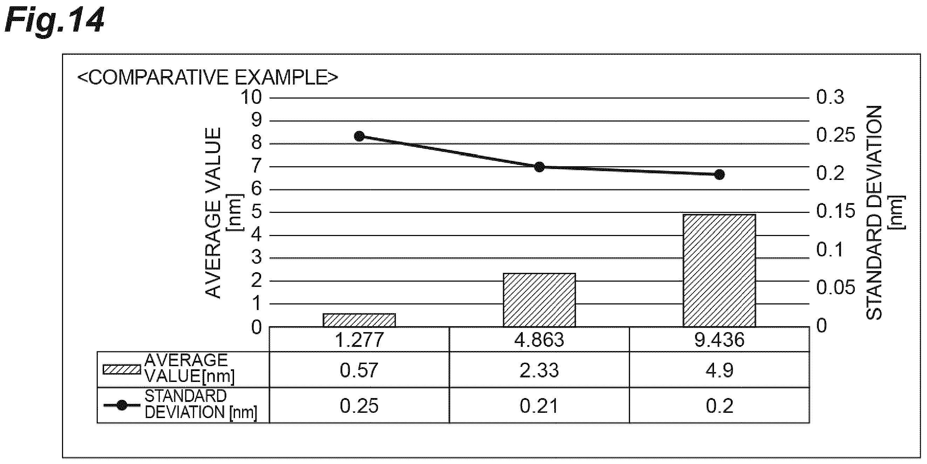

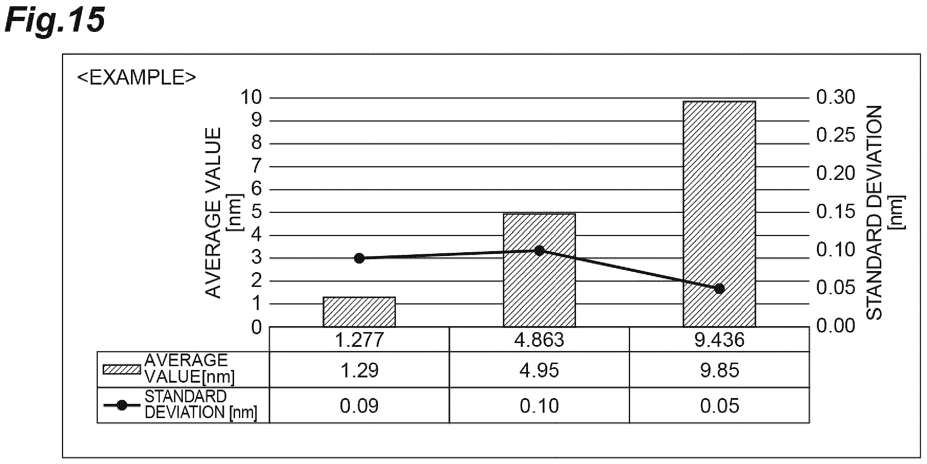

Results of evaluation tests of the film thickness measurement device and the film thickness measurement method according to the present disclosure will now be described. FIG. 14 is a diagram showing results of reproducibility evaluation of film thickness measurement in a Comparative Example. FIG. 15 is a diagram showing results of reproducibility evaluation of film thickness measurement in an Example. In the evaluation test, using a silicon wafer with a SiO₂ film formed thereon as a sample, the thickness of the SiO₂ film was measured 10 times, and then the average value and the standard deviation of the measurement results were calculated. The film thickness of the SiO₂ film in the sample was set to three types of 1 nm, 5 nm, and 10 nm.

In the Comparative Example, curve fitting between reflectance spectrum data of the sample and theoretical reflectance spectrum data was performed using reflectance spectrum data obtained by a common calculation technique (see FIG. 11(a)). In the Example, curve fitting between reflectance spectrum data of the sample and theoretical reflectance spectrum data was performed using reflectance spectrum data obtained by the calculation technique of the present embodiment (see FIG. 11(b)).

As shown in FIG. 14, in the Comparative Example, the average value of the measurement results for the sample having a film thickness of 1 nm was 0.57, and the standard deviation was 0.25. The average value of the measurement results for the sample having a film thickness of 5 nm was 2.33, and the standard deviation was 0.21. The average value of the measurement results for the sample having a film thickness of 10 nm was 4.9, and the standard deviation was 0.2.

In contrast, as shown in FIG. 15, in the Example, the average value of the measurement results for the sample having a film thickness of 1 nm was 1.29, and the standard deviation was 0.09. The average value of the measurement results for the sample having a film thickness of 5 nm was 4.95, and the standard deviation was 0.10. The average value of the measurement results for the sample having a film thickness of 10 nm was 9.85, and the standard deviation was 0.05. From these results, it has been confirmed that the technique according to the present embodiment enhances the accuracy of film thickness measurement and furthermore contributes to improvement of reproducibility.

### Reference Signs List

- 1: film thickness measurement device
- 2: light source
- 5: spectral separation unit
- 6: detection unit
- 7: generation unit
- 8: analysis unit
- 21A: first pixel region
- 21B: second pixel region
- 32A: first horizontal shift register
- 32B: second horizontal shift register
- 41A: first accumulation unit
- 41B: second accumulation unit
- 42A: first readout unit
- 42B: second readout unit
- 57A: first readout unit
- 57B: second readout unit
- L: measurement light
- D1: first direction
- D2: second direction
- M: sample
- P: spectral image
- V1, V2: CCD photodetector
- V3: CMOS photodetector
- λr: boundary wavelength

## Claims

1. A film thickness measurement device comprising:
a spectral separation unit configured to spectrally separate measurement light outputted from a light source and reflected by a sample;
a detection unit configured to detect spectral images of the measurement light spectrally separated by the spectral separation unit;
a generation unit configured to generate spectrum data for analysis by using spectrum data obtained from a result of detection of spectral images of the measurement light; and
an analysis unit configured to analyze a film thickness of the sample on the basis of the spectrum data for analysis, wherein
the spectral separation unit subjects the measurement light to wavelength resolution in a first direction and forms spectral images on a wavelength basis each in a second direction intersecting the first direction,
the detection unit has a first pixel region and a second pixel region divided in the second direction, and receives spectral images of the measurement light with the first pixel region with a first type of exposure time and receives spectral images of the measurement light with the second pixel region with a second type of exposure time longer than the first type of exposure time, and
the generation unit combines data in a long wavelength region in a first type of measurement spectrum data obtained from the first pixel region and data in a short wavelength region in a second type of measurement spectrum data obtained from the second pixel region, and generates the spectrum data for analysis.

2. The film thickness measurement device according to claim 1, wherein the detection unit is a CCD photodetector including:
a first horizontal shift register to which charge generated in each column of the first pixel region is transferred; and
a second horizontal shift register to which charge generated in each column of the second pixel region is transferred.

3. The film thickness measurement device according to claim 1, wherein the detection unit is a CCD photodetector including:
a first accumulation unit in which charge generated in each column of the first pixel region is accumulated;
a second accumulation unit in which charge generated in each column of the second pixel region is accumulated;
a first readout unit configured to output an electrical signal of each column according to an amount of charge accumulated in the first accumulation unit; and
a second readout unit configured to output an electrical signal of each column according to an amount of charge accumulated in the second accumulation unit.

4. The film thickness measurement device according to claim 1, wherein the detection unit is a CMOS photodetector including:
a first readout unit configured to output charge generated in each column of the first pixel region; and
a second readout unit configured to output charge generated in each column of the second pixel region.

5. The film thickness measurement device according to any one of claims 1 to 4, wherein the generation unit sets a boundary wavelength between data in the long wavelength region in the first type of measurement spectrum data and data in the short wavelength region in the second type of measurement spectrum data when generating the spectrum data for analysis on the basis of an exposure time ratio between the first pixel region and the second pixel region and an estimated value of reflection spectrum data in the sample.

6. The film thickness measurement device according to claim 5, wherein the generation unit sets the boundary wavelength from wavelengths at which a peak intensity of the measurement light included in the data in the short wavelength region is 80% or more and less than 100% of a saturation intensity.

7. A film thickness measurement method comprising:
a spectral separation step of spectrally separating measurement light outputted from a light source and reflected by a sample;
a detection step of detecting spectral images of the measurement light spectrally separated by the spectral separation step;
a generation step of generating spectrum data for analysis by using spectrum data obtained from a result of detection of spectral images of the measurement light; and
an analysis step of analyzing a film thickness of the sample on the basis of the spectrum data for analysis, wherein
the spectral separation step subjects the measurement light to wavelength resolution in a first direction and forms spectral images on a wavelength basis each in a second direction intersecting the first direction,
the detection step uses a first pixel region and a second pixel region divided in the second direction to receive spectral images of the measurement light with the first pixel region with a first type of exposure time and receive spectral images of the measurement light with the second pixel region with a second type of exposure time longer than the first type of exposure time, and
the generation step combines data in a long wavelength region in a first type of measurement spectrum data obtained from the first pixel region and data in a short wavelength region in a second type of measurement spectrum data obtained from the second pixel region, and generates the spectrum data for analysis.
